# EUROPEAN PATENT APPLICATION

(11) **EP 3 288 065 A1**
(43) Date of publication of application: **28.02.2018**
(21) Application number: 17185488.8
(22) Date of filing: 09.08.2017
(51) Int. Cl.: H01L 21/768, H01L 21/8238

(54) **SEMICONDUCTOR STRUCTURE AND FABRICATION METHOD THEREOF**

(30) Priority: 12.08.2016 CN 201610664338
(71) Applicant: Semiconductor Manufacturing International Corporation (Shanghai), Shanghai 201203 (CN); Semiconductor Manufacturing International Corporation (Beijing), Beijing 100176 (CN)
(72) Inventor: XIE, Xinyun, Shanghai, 201203 (CN)
(74) Representative: Klunker IP Patentanwälte PartG mbB

(57) **Abstract**

A semiconductor structure and a method for fabricating the semiconductor structure are provided. The method includes forming a base substrate (200), including a substrate, a gate structure (222) on the substrate, source and drain doped regions (212) in the substrate on both sides of the gate structure, and a dielectric layer on the substrate and on top of the gate structure. The method also includes forming a contact hole (240), penetrating through the dielectric layer, wherein a bottom of the contact hole extends into each of the source and drain doped regions. In addition, the method includes forming a doped layer (252), in each of the source and drain doped regions by a doping process via the bottom and a portion of sidewalls of the contact hole. Further, the method includes forming a conductive plug in the contact hole.

## Description

### CROSS-REFERENCES TO RELATED APPLICATIONS

This application claims the priority of Chinese patent application No. 201610664338.6, filed on August 12, 2016

### FIELD OF THE DISCLOSURE

The present invention generally relates to the field of semiconductor manufacturing technology and, more particularly, relates to a semiconductor structure and fabrication method thereof.

### BACKGROUND

With continuous development of semiconductor technology, feature dimensions of semiconductor devices continue to decrease. The reduction of the critical dimensions of the semiconductor devices means that a greater number of transistors can be placed on a single chip, which at the same time, raises higher requirements for semiconductor process.

Source and drain doped regions and a gate structure are important components of a transistor. The transistor is electrically connected to external circuits by forming a conductive plug on each of the source and drain doped regions. Concentration of doped ions in the source and drain doped regions greatly affects a contact resistance between the conductive plug and each of the source and drain doped regions. The higher the concentration of the doped ions in the source and drain doped regions, the smaller the contact resistance thereof. Therefore, the contact resistance is usually reduced by doping the source and drain doped regions before forming the conductive plug.

However, distribution of the contact resistivity between each of the source and drain doped regions and the conductive plug in a conventionally-formed semiconductor structure is non-uniform, and the performance of the semiconductor structure is unstable.

### BRIEF SUMMARY OF THE DISCLOSURE

It is an object of the present invention to provide a semiconductor structure and a method for fabricating the same which may solve one or more problems set forth above and other problems, in particular in which a improved uniformity of the distribution of the contact resistivity between each of a source and drain doped regions and a conductive plug is improved resulting in an improved stability of the performance of the semiconductor structure.

A first aspect of the present invention provides a method for fabricating a semiconductor structure.

The method includes forming a base substrate, including a substrate, a gate structure on the substrate, source and drain doped regions in the substrate on both sides of the gate structure, and a dielectric layer on the substrate and on top of the gate structure. The method also includes forming a contact hole, penetrating through the dielectric layer, wherein a bottom of the contact hole extends into each of the source and drain doped regions. In addition, the method includes forming a doped layer, in each of the source and drain doped regions by a doping process via the bottom and a portion of sidewalls of the contact hole. Further, the method includes forming a conductive plug in the contact hole.

Preferably, the doping process is an isotropic process.

Preferably, the doping process includes a plasma doping process.

If the semiconductor structure includes an NMOS transistor, preferably, the doped layer is doped with one or more of phosphorus ions, arsenic ions, and antimony ions.

If the semiconductor structure includes a PMOS transistor, preferably, the doped layer is doped with one or more of boron ions and indium ions.

Preferably, a concentration of doped ions in the doped layer is greater than 5×1014 atoms/cm3.

Preferably, a doping dose is in a range of approximately 1×1015 atoms/cm3 - 5×1015 atoms/cm3.

Preferably, a doping energy is in a range of approximately 10 eV - 20 KeV.

Preferably, a pressure is in a range of approximately 1 mtorr - 1000 mtorr.

Preferably, a doping temperature is in a range of approximately 25 °C - 800 °C.

Preferably, before forming the conductive plug in the contact hole, further including: performing an anti-diffusion treatment on the doped layer.

Preferably, the anti-diffusion treatment is performed on the doped layer by an ion implantation process to dope the doped layer with heavy ions.

Preferably, an atomic weight of the heavy ions is larger than an atomic weight of ions doped in the doped layer.

Preferably, the anti-diffusion treatment is performed on the doped layer by a plasma doping process to dope the doped layer with heavy ions.

Preferably, an atomic weight of the heavy ions is larger than an atomic weight of ions doped in the doped layer.

If the source and drain doped regions are for forming an NMOS transistor, preferably, the doped ions include phosphorus ions, and the heavy ions include one or more of arsenic ions and antimony ions.

If the source and drain doped regions are for forming a PMOS transistor, preferably, the doped ions include boron ions, and the heavy ions include indium ions.

Preferably, process parameters of the ion implantation process include: an implantation energy in a range of approximately 200 eV - 20 KeV; an implantation dose lower than 1×1014 atoms/cm3; and an implantation angle in a range of approximately 0° - 20°.

Preferably, after forming the doped layer and before forming the conductive plug, further including: forming a metal layer on the bottom and sidewalls of the contact hole, wherein the metal layer in contact with the doped layer reacts with the doped layer to form metal compounds.

Preferably, the base substrate includes a first transistor region and a second transistor region.

Preferably, he gate structure includes a first gate structure in the first transistor region and a second gate structure in the second transistor region.

Preferably, the source and drain doped regions include first source and drain doped regions in the substrate on both sides of the first gate structure in the first transistor region, and second source and drain doped regions in the substrate on both sides of the second gate structure in the second transistor region.

Preferably, the doped layer includes a first doped layer on a surface of each of the first source and drain doped regions, and a second doped layer on a surface of each of the second source and drain doped regions.

Preferably, wherein the doping process for doping the source and drain doped regions includes: forming a first photoresist layer in the contact hole and on the dielectric layer in the first transistor region; doping the second source and drain doped regions by a second doping process with the first photoresist layer as a mask to form the second doped layer in each of the second source and drain doped regions via the bottom and a portion of sidewalls of the contact hole in the second transistor region; removing the first photoresist layer; forming a second photoresist layer in the contact hole and on the dielectric layer in the second transistor region; doping the first source and drain doped regions by a first doping process with the second photoresist layer as a mask to form the first doped layer in each of the first source and drain doped regions via the bottom and a portion of sidewalls of the contact hole in the first transistor region; and removing the second photoresist layer.

Preferably, before forming the conductive plug in the contact hole, further including: performing an anti-diffusion treatment on the doped layer.

Preferably, the anti-diffusion treatment includes: performing a second anti-diffusion treatment on the second doped layer with the first photoresist layer as a mask after doping the second source and drain doped regions by the second doping process; and performing a first anti-diffusion treatment on the first doped layer with the second photoresist layer as a mask after doping the first source and drain doped regions by the first doping process.

A second aspect of the present invention includes a semiconductor structure.

The semiconductor structure includes a base substrate, including a substrate, a gate structure on the substrate, source and drain doped regions in the substrate on both sides of the gate structure, and a dielectric layer on the substrate and on top of the gate structure. The semiconductor structure also includes a conductive plug, penetrating through the dielectric layer and into each of the source and drain doped regions. Further, the semiconductor structure includes a doped layer in each of the source and drain doped regions, with doped ions, and surrounding a bottom portion of the conductive plug.

Preferably, the base substrate includes a first transistor region and a second transistor region.

Preferably, the gate structure includes a first gate structure in the first transistor region and a second gate structure in the second transistor region.

Preferably, the source and drain doped regions include first source and drain doped regions in the substrate on both sides of the first gate structure in the first transistor region, and second source and drain doped regions in the substrate on both sides of the second gate structure in the second transistor region.

Preferably, the doped layer includes a first doped layer on a surface of each of the first source and drain doped regions, and a second doped layer on a surface of each of the second source and drain doped regions.

Preferably, the doped ions include first doped ions in the first doped layer, and second doped ions in the second doped layer.

Preferably, the first transistor region includes an NMOS transistor, and the first doped ions include one or more of phosphorus ions, arsenic ions, and antimony ions.

Preferably, the second transistor region includes a PMOS transistor, and the second doped ions include one or more of boron ions and indium ions.

Other aspects of the present invention can be understood by those skilled in the art in light of the description, the claims, and the drawings of the present invention.

### BRIEF DESCRIPTION OF THE DRAWINGS

Figures 1-3 illustrate semiconductor structures corresponding to certain stages for forming a semiconductor structure;
Figures 4-11 illustrate semiconductor structures corresponding to certain stages of an exemplary fabrication method for forming a semiconductor structure consistent with various disclosed embodiments of the present invention ; and
Figure 12 illustrates an exemplary fabrication method for forming a semiconductor structure consistent with various disclosed embodiments of the present invention.

### DETAILED DESCRIPTION

Reference will now be made in detail to exemplary embodiments of the disclosure, which are illustrated in the accompanying drawings. Wherever possible, the same reference numbers will be used throughout the drawings to refer to the same or the alike parts.

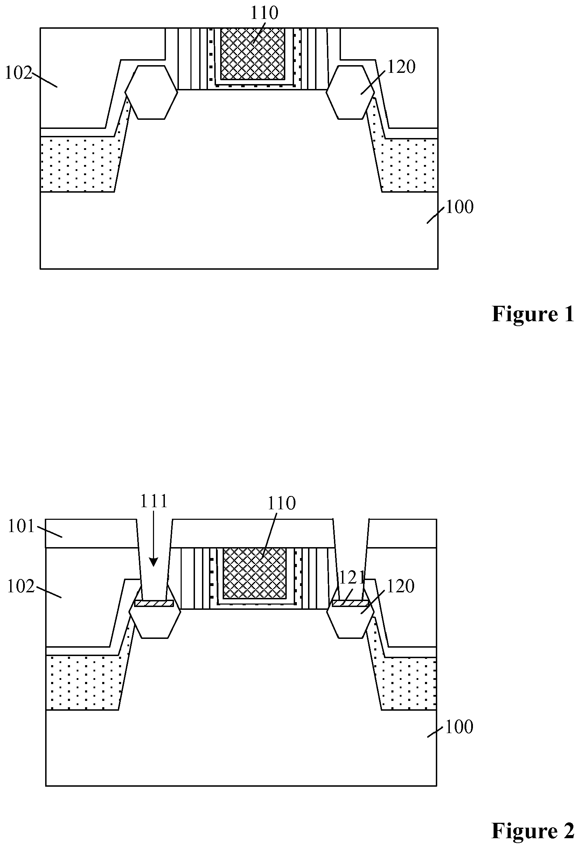

Figures 1-3 illustrate semiconductor structures corresponding to certain stages for forming a semiconductor structure. Referring to Figure 1, a base substrate is provided. The base substrate includes a substrate 100, a gate structure 110 formed on the substrate 100, and source and drain doped regions 120 formed in the substrate 100 on both sides of the gate structure 110, and a bottom dielectric layer 102 formed on the substrate 100 as well as the source and drain doped regions 120.

Referring to Figure 2, a dielectric layer 101 is formed on the base substrate and a contact hole 111 penetrating through the dielectric layer 101 is formed. Bottom of the contact hole 111 extends into each of the source and drain doped regions 120. After forming the contact hole 111, an ion implantation process is performed on the source and drain doped regions 120 to form a doped layer 121 in each of the source and drain doped regions 120 via the bottom of the contact hole 111.

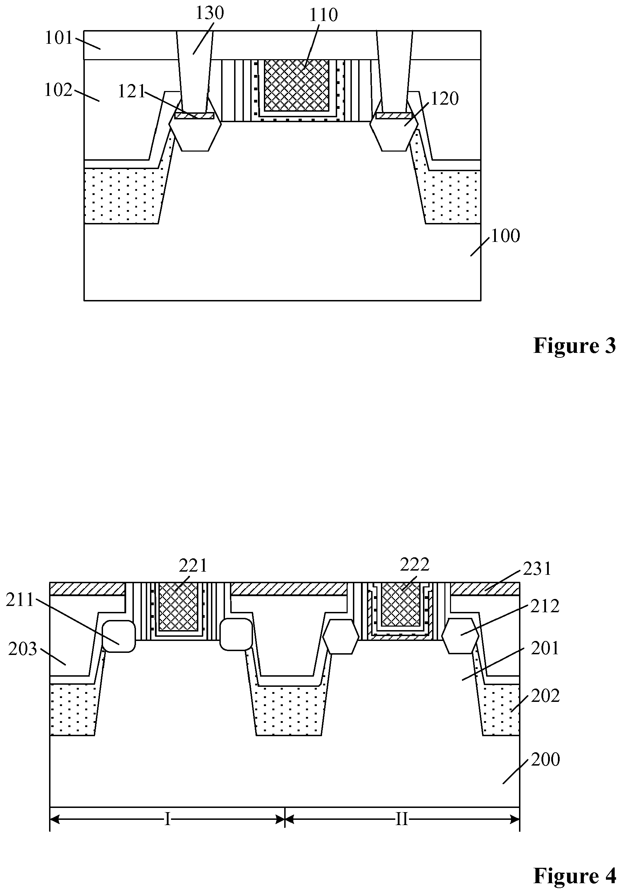

Referring to Figure 3, a conductive plug 130 is formed in the contact hole 111 (shown in Figure 2). The ion implantation process is a directional process. When performing the ion implantation process on the source and drain doped regions 120, concentration of implanted ions in each of the source and drain doped regions 120 under the contact hole 111 is high, thus the contact resistivity between the conductive plug 130 and each of the source and drain doped regions 120 under the conductive plug 130 is small. However, concentration of implanted ions in each of the source and drain doped regions 120 on sidewalls of the contact hole 111 is small, thus the contact resistivity between the conductive plug 130 and each of the source and drain doped regions 120 exposed by the sidewalls of the contact hole is large. In other words, distribution of the contact resistivity between each of the source and drain doped regions 120 and the conductive plug 130 is non-uniform, and the performance of the formed semiconductor structure is poor.

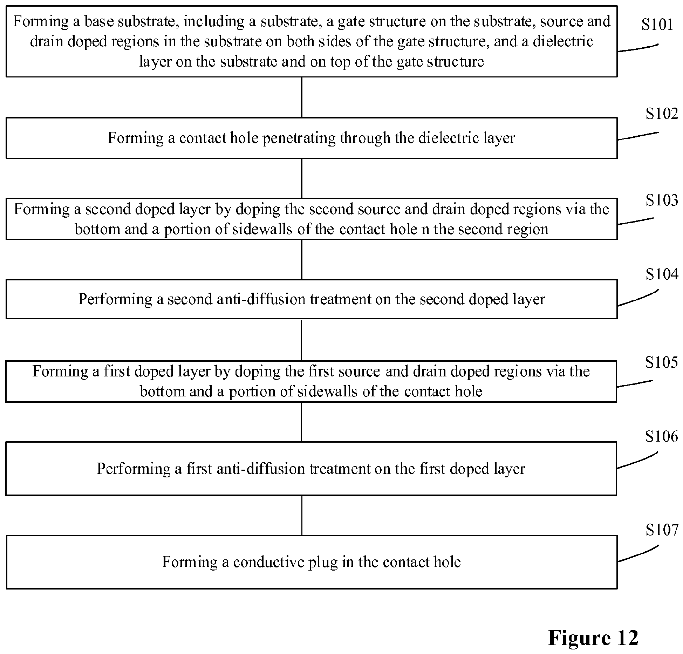

The present invention provides a semiconductor structure and fabrication method thereof. Figure 12 illustrates an exemplary fabrication method for forming a semiconductor structure consistent with various disclosed embodiments of the present invention ; and Figures 4-11 illustrate semiconductor structures corresponding to certain stages of the exemplary fabrication method.

As shown in Figure 12, at the beginning of the fabrication method, a base substrate with certain structures may be provided (S101). Figures 4-5 illustrate corresponding semiconductor structures.

Referring to Figures 4-5, a base substrate may be provided. The base substrate may include a substrate, a gate structure formed on the substrate, source and drain doped regions in the substrate on both sides of the gate structure, and a dielectric layer formed on the substrate and on the gate structure.

In one embodiment, the base substrate may include a first transistor region I and a second transistor region II. The first transistor region I may be used to form an NMOS transistor, and the second transistor region II may be used to form a PMOS transistor. In certain embodiments, the first transistor region I may be used to form a PMOS transistor, and the second transistor region II may be used to form an NMOS transistor.

In one embodiment, the dielectric layer may include a bottom dielectric layer 203 on the substrate, and a top dielectric layer 230 on the bottom dielectric layer 203 and on the top of the gate structure.

A method for forming the base substrate may include the following steps shown in Figures 4-5. Referring to Figure 4, forming the base substrate may include: providing the substrate, forming the gate structure on the substrate, forming source and drain doped regions in the substrate on both sides of the gate structure, and forming the bottom dielectric layer 203 on the substrate and the source and drain doped regions. The bottom dielectric layer 203 may expose the top of the gate structure.

In one embodiment, forming the substrate may include: providing an initial substrate, and patterning the initial substrate to form the bottom substrate 200 and a plurality of fins 201 on the bottom substrate 200. In certain embodiments, the substrate may be a planar substrate.

In one embodiment, the bottom substrate 200 may be a silicon substrate. In certain embodiments, the bottom substrate 200 may be a germanium substrate, a silicon germanium substrate, a silicon on insulator substrate, a germanium on insulator substrate, or other semiconductor substrates. In one embodiment, the fins 201 may be made of silicon. In certain embodiments, the fins 201 may be made of germanium, or silicon germanium, etc.

In one embodiment, the base substrate may also include an isolation structure 202 formed on the bottom substrate 200 between the adjacent fins 201. The surface of the isolation structure 202 may be lower than the top surface of the fin 201.

In one embodiment, the gate structure may include a first gate structure 221 formed on the fin 201 in the first transistor region I, and a second gate structure 222 formed on the fin 201 in the second transistor region II.

In one embodiment, the first gate structure 221 may include a first gate dielectric layer formed on the fin 201 in the first transistor region I, a first working function layer formed on the first gate dielectric layer, a first capping layer formed on the first working function layer, and a first gate formed on the first capping layer.

In one embodiment, the second gate structure 222 may include a second gate dielectric layer formed on the fin 201 in the second transistor region II, the first working function layer formed on the second gate dielectric layer, a second working function layer formed on the first working function layer, a second capping layer formed on the second working function layer, and a second gate formed on the second capping layer.

In one embodiment, both the first gate and the second gate may be a metal gate. For example, both the first gate and the second gate may be made of tungsten. In one embodiment, the first gate structure 221 and the second gate structure 222 may be formed by a gate-last process.

In one embodiment, the base substrate may also include a barrier layer 231 formed on the bottom dielectric layer 203.

In one embodiment, forming the first gate structure 221 and the second gate structure 222 may include: forming a first dummy gate structure on the fin 201 in the first transistor region I; forming a second dummy gate structure on the fin 201 in the second transistor region II; sequentially forming the bottom dielectric layer 203 and the barrier layer 231 over the isolation structure 202 and the fins 201; removing the first dummy gate structure to form a first opening; removing the second dummy gate structure to form a second opening; forming the first gate structure 221 in the first opening; and forming the second gate structure 222 in the second opening.

The bottom dielectric layer 203 may be used to electrically isolate the first gate structure 221, the second gate structure 222 and external circuits. The barrier layer 231 may be used to protect the bottom dielectric layer 203.

In one embodiment, the gate-last process used to form the metal gate structure is described herein as an example. In another embodiment, the first gate and the second gate may be a polysilicon gate. The dummy gate may provide a space for forming a polysilicon gate of the polysilicon gate transistor. In certain embodiments, the base substrate may be formed by a front-gate process, and the base substrate may not include the bottom dielectric layer and the barrier layer.

In one embodiment, the source and drain doped regions may include first source and drain doped regions 211 formed in the fin 201 on both sides of the first gate structure 221, and second source and drain doped regions 212 formed in the fin 201 on both sides of the second gate structure 222.

In one embodiment, after forming the first dummy gate structure and the second dummy gate structure, and before forming the bottom dielectric layer, the first source and drain doped regions 211 may be formed in the fin 201 on both sides of the first dummy gate structure, and the second source and drain doped regions 212 may be formed in the fin 201 on both sides of the second dummy gate structure.

In one embodiment, the first source and drain doped regions 211 and the second source and drain doped regions 212 may be formed by an epitaxial growth process. The first source and drain doped regions 211 and the second source and drain doped regions 212 may be doped during the epitaxial growth process.

In one embodiment, the first transistor region I may be used to form an NMOS transistor, the first source and drain doped regions 211 may be made of silicon carbon, and the doped ions in the first source and drain doped regions 211 may be phosphorus ions.

In one embodiment, the second transistor region II may be used to form a PMOS transistor, the second source and drain doped regions 212 may be made of silicon germanium, and the doped ions in the second source and drain doped regions 212 may be boron ions.

In one embodiment, the base substrate may also include a sidewall spacer formed between the gate structure and the bottom dielectric layer 203.

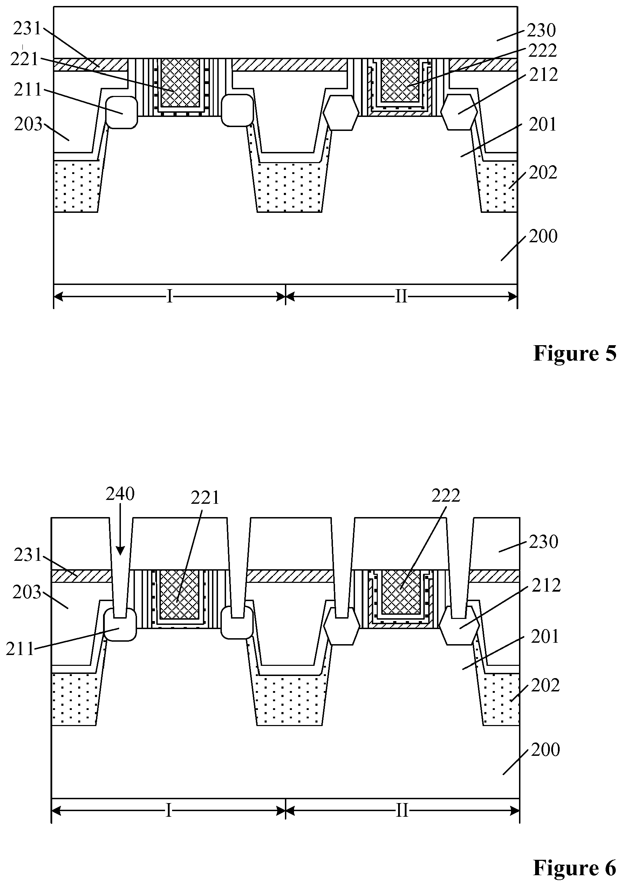

Referring to Figure 5, after forming the first gate structure 221 and the second gate structure 222, forming the base substrate may include forming a top dielectric layer 230 on the bottom dielectric layer 203 and on the gate structure. The top dielectric layer 230 may be used to isolate the base substrate and the external circuits.

In one embodiment, the top dielectric layer 230 may be made of silicon oxide. In certain embodiments, the top dielectric layer 230 may be made of silicon oxynitride. In one embodiment, the top dielectric layer 230 may be formed by one of a chemical vapor deposition process, a physical vapor deposition process, and an atomic layer deposition process.

Returning to Figure 12, after forming the top dielectric layer, a contact hole may be formed (S102). Figure 6 illustrates a corresponding semiconductor structure.

Referring to Figure 6, a contact hole 240 penetrating through the dielectric layer may be formed. The bottom of the contact hole 240 may extend into each of the source and drain doped regions. The contact hole 240 may be subsequently used to accommodate a conductive plug, thereby the source and drain doped regions may be electrically connected to the external circuits.

In one embodiment, forming the contact hole 240 may include etching the dielectric layer. The etching process performed on the dielectric layer may include a dry etching process. The etching rate of the dry etching process in the lateral direction may be small, thus the verticality of the sidewall of the formed contact hole 240 may be desired. In one embodiment, forming the contact hole 240 may also include etching the barrier layer 231.

After forming the contact hole 240, the source and drain doped regions may be doped by a doping process to form a doped layer in each of the source and drain doped regions via the bottom and a portion of sidewalls of the contact hole 240. The ions doped into the source and drain doped regions can be referred to doped ions.

In one embodiment, the doped layer may include a first doped layer in each of the first source and drain doped regions 211, and a second doped layer in each of the second source and drain doped regions 212. The doped ions may include first doped ions in the first doped layer, and second doped ions in the second doped layer.

In one embodiment, the doping process to dope the source and drain doped regions may include: a first doping process to dope the first source and drain doped regions 211 to form the first doped layer in each of the first source and drain doped regions 211 via the bottom and a portion of sidewalls of the contact hole 240 in the first transistor region I; and a second doping process to dope the second source and drain doped regions 212 to form the second doped layer in each of the second source and drain doped regions 212 via the bottom and a portion of sidewalls of the contact hole 240 in the second transistor region II.

After forming the doped layer, an anti-diffusion treatment may be performed on the doped layer. The anti-diffusion treatment performed on the doped layer may include a first anti-diffusion treatment performed on the first doped layer, and a second anti-diffusion treatment performed on the second doped layer.

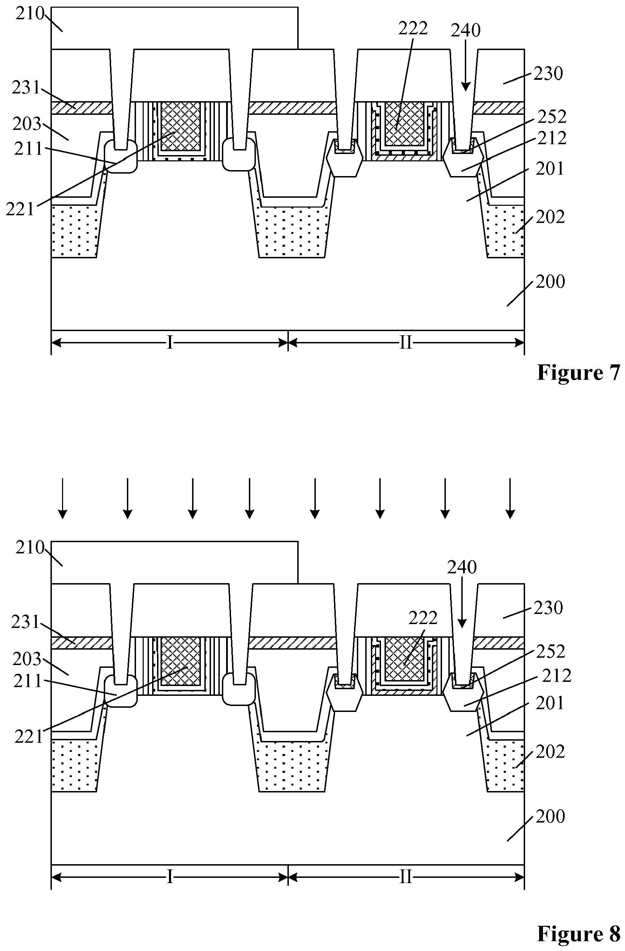

Returning to Figure 12, after forming the contact hole, a second doped layer may be formed (S103). Figure 7 illustrates a corresponding semiconductor structure.

Referring to Figure 7, a second doping process may be performed on the second source and drain doped regions 212 to dope the second source and drain doped regions 212 with the second doped ions, thus a second doped layer 252 may be formed in each of the second source and drain doped regions 212 via the bottom and a portion of sidewalls of the contact hole 240 in the second transistor region II. The second doped layer 252 may be used to reduce the resistance between each of the second source and drain doped regions 212 and a subsequently formed conductive plug.

The second doping process may be an isotropic process. In other words, the second doping process may be capable of doping the second source and drain doped regions 212 in all directions, and doping concentration in each direction may be uniform. Therefore, the second doping process may be capable of doping the bottom and sidewalls of the contact hole 240 in the second transistor region II. Thus the second doped layer 252 may be formed in each of the second source and drain doped regions 212 via the bottom and a portion of sidewalls of the contact hole 240 in the second transistor region II.

The second doping process may be an isotropic process and the concentration of the second doped ions in the second doped layer 252 may be uniform, thus the resistivity between the subsequently formed conductive plug and each of the second source and drain doped regions 212 may be uniform. Therefore, the performance of the formed semiconductor structure may be improved.

In one embodiment, the second doping process to dope the second source and drain doped regions 212 may include: forming a first photoresist layer 210 in the contact hole 240 and on the top dielectric layer 230 in the first transistor region I; doping the second source and drain doped regions 212 by the second doping process with the first photoresist layer 210 as a mask to form the second doped layer 252 in each of the second source and drain doped regions 212 via the bottom and a portion of sidewalls of the contact hole 240 in the second transistor region II; and removing the first photoresist layer 210.

In one embodiment, the process of forming the first photoresist layer 210 may include a spin coating process. In one embodiment, the second transistor region II may be used to form a PMOS transistor, thus the second doped ions may be boron ions. In certain embodiments, the second doped ions may be indium ions.

In one embodiment, the second doping process may include a plasma doping process. The plasma doping process is based on the diffusion of plasma into the second source and drain doped regions 212 to dope the second source and drain doped regions 212. The diffusion of plasma is isotropic, and the scattering between plasmas may also increase the uniformity of the doped concentration. Therefore, the plasma doping process may enable isotropic doping.

If the concentration of the second doped ions in the second doped layer 252 is too small, the resistance between each of the second source and drain doped regions 212 and the subsequently formed conductive plug may not be effectively reduced. In one embodiment, the concentration of the second doped ions in the second doped layer 252 may be greater than 5×10¹⁴ atoms/cm³.

The doping dose is related to the doping concentration. The too low doping dose may cause the doping concentration to be too low, and the too large doping dose may easily waste materials. In one embodiment, the doping dose may be in a range of approximately 1×10¹⁵ atoms/cm³ - 5×10¹⁵ atoms/cm³.

In one embodiment, the small doping energy of the second doping process may reduce the directivity of the second doping process. While if the doping energy is too small, the doping efficiency may be affected. Therefore, the doping energy may be in a range of approximately 10 eV - 20 KeV.

In one embodiment, the higher the doping temperature, the higher the diffusion rate of the plasma into the second source and drain doped regions, and the higher the production efficiency. However, the high temperature may easily degrade the performance of the semiconductor structure. For example, in one embodiment, the doping temperature may be in a range of approximately 25 °C - 800 °C.

In one embodiment, the lower the pressure, the higher the vacuum degree, and the smaller the influence on the plasma diffusion. The too high vacuum degree may easily increase the equipment requirements. Therefore, in one embodiment, the vacuum degree may be in a range of approximately 1 mtorr - 1000 mtorr.

Returning to Figure 12, after forming the second doped layer, a second anti-diffusion treatment may be performed on the second doped layer (S104). Figure 8 illustrates a corresponding semiconductor structure.

Referring to Figure 8, after doping the second source and drain doped regions 212 by the second doping process, a second anti-diffusion treatment may be performed on the second doped layer 252. The second anti-diffusion treatment may be used to reduce the diffusion of the second doped ions in the second doped layer 252 toward the surface of the second doped layer 252, so as to reduce the loss of the second doped ions.

In one embodiment, the second anti-diffusion treatment may include performing a second ion implantation process on the second doped layer 252. The implanted ions in the second ion implantation process may be referred to second anti-diffusion ions. When performing the second ion implantation process, the second anti-diffusion ions may have a certain kinetic energy and may collide with the second doped ions, as a result, the second doped ions may be moved toward the inside of the second doped layer 252.

In one embodiment, the atomic weight of the second anti-diffusion ion may be larger than the atomic weight of the second doped ion. In certain embodiments, the atomic weight of the second anti-diffusion ion may be equal to or smaller than the atomic weight of the second doped ion.

If the atomic weight of the second anti-diffusion ion is larger than the atomic weight of the second doped ion, the second doped ions may be easily moved toward the inside of the second doped layer 252 when performing the second ion implantation process. Therefore, the loss of the second doped ions may be reduced. In one embodiment, the second doped ions may be boron ions, and the second anti-diffusion ions may be indium ions.

In one embodiment, the process parameters of the second anti-diffusion treatment performed on the second doped layer 252 by the second ion implantation process may include the following. The implantation energy may be in a range of approximately 200 eV - 20 KeV, the implantation dose may be lower than 1×10¹⁴ atoms/cm³, and the implantation angle may be in a range of approximately 0° - 20°.

In certain embodiments, the second anti-diffusion treatment may be performed on the second doped layer by a plasma doping process to dope the second doped layer with heavy ions. The atomic weight of the heavy ion may be larger than the atomic weight of the second doped ion.

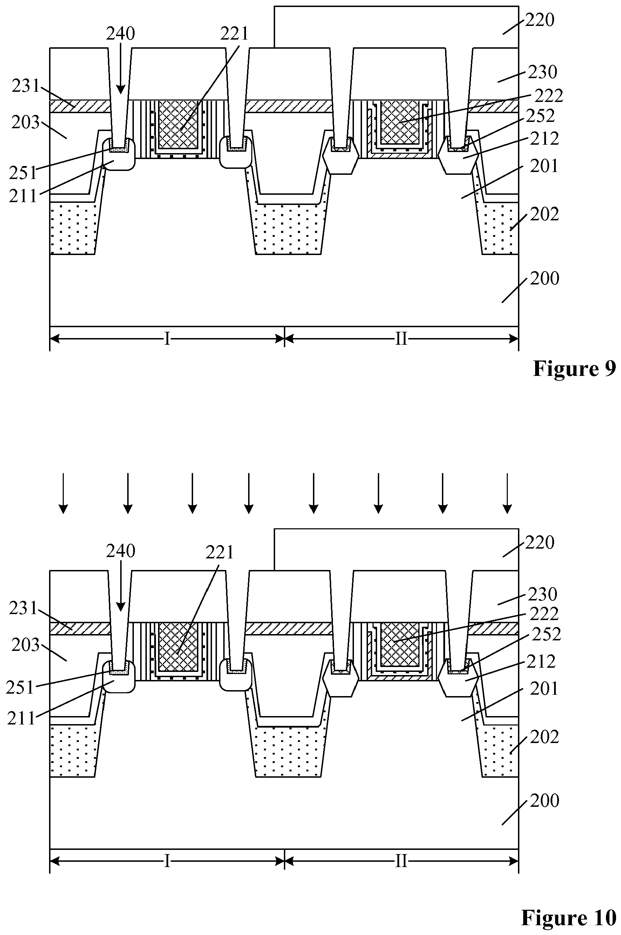

Returning to Figure 12, after performing the second anti-diffusion treatment, a first doped layer may be formed (S105). Figure 9 illustrates a corresponding semiconductor structure.

Referring to Figure 9, after performing the second anti-diffusion treatment, a first doping process may be performed on the first source and drain doped regions 211 to dope the first source and drain doped regions 211 with first doped ions, thus a first doped layer 251 may be formed in each of the first source and drain doped regions 211 via the bottom and a portion of sidewalls of the contact hole 240 in the first transistor region I. The first doped layer 251 may be used to reduce the resistance between each of the first source and drain doped regions 211 and the subsequently formed conductive plug.

The first doping process may be an isotropic process. In other words, the first doping process may be capable of doping the first source and drain doped regions 211 in all directions, and doping concentration in each direction may be uniform. Therefore, the first doping process may be capable of doping the bottom and a portion of sidewalls of the contact hole 240 in the first transistor region I. The first doped layer 251 may be formed in each of the first source and drain doped regions 211 via the bottom and a portion of sidewalls of the contact hole 240 in the first transistor region I.

The first doping process may be an isotropic process and the concentration of the first doped ions in the first doped layer 251 may be uniform, thus the resistivity between the subsequently formed conductive plug and each of the first source and drain doped regions 211 may be uniform. Thus, the performance of the formed semiconductor structure may be improved.

In one embodiment, the first doping process to dope the first source and drain doped regions 211 may include: forming a second photoresist layer 220 in the contact hole 240 and on the top dielectric layer 230 in the second transistor region II; doping the first source and drain doped regions 211 by the first doping process with the second photoresist layer 220 as a mask to form the first doped layer 251 in each of the first source and drain doped regions 211 via the bottom and a portion of idewalls of the contact hole 240 in the first transistor region I; and removing the second photoresist layer 220.

In one embodiment, the process of forming the second photoresist layer 220 may include a spin coating process. In one embodiment, the first transistor region I may be used to form an NMOS transistor, thus the first doped ions may be phosphorus ions. In certain embodiments, the first doped ions may be arsenic ions, or antimony ions, etc.

In one embodiment, the first doping process may include a plasma doping process. The plasma doping process is based on the diffusion of plasma into the first source and drain doped regions 211 to dope the first source and drain doped regions 211. The diffusion of plasma is isotropic, and the scattering between plasmas may also increase the uniformity of the doped concentration. Therefore, the plasma doping process may enable isotropic doping.

If the concentration of the first doped ions in the first doped layer 251 is too small, the resistance between each of the first source and drain doped regions 211 and the subsequently formed conductive plug may not be effectively reduced. In one embodiment, the concentration of the first doped ions in the first doped layer 251 may be greater than 5×10¹⁴ atoms/cm³.

The doping dose may be related to the doping concentration. The too low doping dose may cause the doping concentration to be too low, and the too large doping dose may easily waste materials. In one embodiment, the doping dose may be in a range of approximately 1×10¹⁵ atoms/cm³ - 5×10¹⁵ atoms/cm³.

In one embodiment, the small doping energy of the first doping process may reduce the directivity of the first doping process. While the too small doping energy may affect the doping efficiency. Therefore, the doping energy may be in a range of approximately 10 eV - 20 KeV.

In one embodiment, the higher the doping temperature, the higher the diffusion rate of the plasma into the first source and drain doped regions 211, and the higher the production efficiency. However, the high temperature may easily degrade the performance of the semiconductor structure. For example, in one embodiment, the doping temperature may be in a range of approximately 25 °C - 800 °C.

In one embodiment, the lower the pressure, the higher the vacuum degree, and the smaller the influence on the plasma diffusion. The too high vacuum degree may easily increase the equipment requirements. Therefore, in one embodiment, the vacuum degree may be in a range of approximately 1 mtorr - 1000 mtorr.

Returning to Figure 12, after forming the first doped layer, a first anti-diffusion treatment may be performed on the first doped layer (S106). Figure 10 illustrates a corresponding semiconductor structure.

Referring to Figure 10, after forming the first doped layer 251, a first anti-diffusion treatment may be performed on the first doped layer 251. The first anti-diffusion treatment may be used to reduce the diffusion of the first doped ions in the first doped layer 251 toward the surface of the first doped layer 251, so as to reduce the loss of the first doped ions.

In one embodiment, the first anti-diffusion treatment may include performing a first ion implantation process on the first doped layer 251. The implanted ions in the first ion implantation process may be referred to first anti-diffusion ions. When performing the first ion implantation process, the first anti-diffusion ions may have a certain kinetic energy and may collide with the first doped ions, as a result, the first doped ions may be moved toward the inside of the first doped layer 251.

In one embodiment, the atomic weight of the first anti-diffusion ion may be larger than the atomic weight of the first doped ion. In certain embodiments, the atomic weight of the first anti-diffusion ion may be equal to or smaller than the atomic weight of the first doped ion.

If the atomic weight of the first anti-diffusion ion is larger than the atomic weight of the first doped ion, the first doped ions may be easily moved toward the inside of the first doped layer 251 when performing the first ion implantation process. Therefore, the loss of the first doped ions may be reduced. In one embodiment, the first doped ions may be phosphorus ions, and the first anti-diffusion ions may be arsenic ions, or antimony ions, etc.

In one embodiment, the process parameters of the first anti-diffusion treatment performed on the first doped layer 251 by the first ion implantation process may include the following. The implantation energy may be in a range of approximately 200 eV -20 KeV, the implantation dose may be lower than 1×10¹⁴ atoms/cm³, and the implantation angle may be in a range of approximately 0° - 20°.

In certain embodiments, the first anti-diffusion treatment may be performed on the first doped layer by a plasma doping process to dope the first doped layer with heavy ions. The atomic weight of the heavy ion may be larger than the atomic weight of the first doped ion.

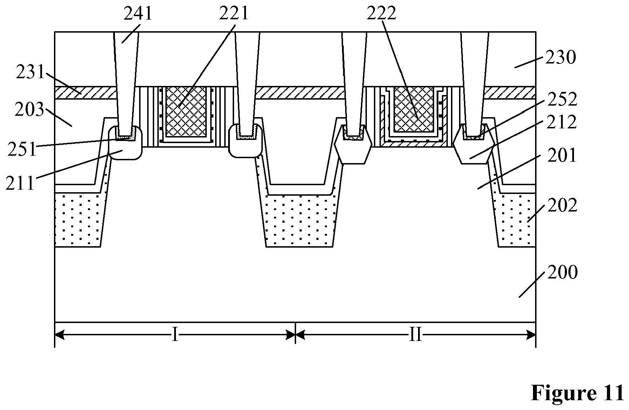

Returning to Figure 12, after performing the first anti-diffusion treatment, a conductive plug may be formed in the contact hole (S107). Figure 11 illustrates a corresponding semiconductor structure.

Referring to Figure 11, a conductive plug 241 may be formed in the contact hole 240. The conductive plug 241 may be used to electrically connect the source and drain doped regions and the external circuits.

In one embodiment, the conductive plug 241 may be made of tungsten. In certain embodiments, the conductive plug 241 may be made of copper. In one embodiment, the conductive plug 241 may be formed by a chemical vapor deposition process. The conductive plug 241, formed by the chemical vapor deposition process, may have a desired step coverage.

In one embodiment, before forming the conductive plug 241, a metal layer may be formed on the bottom and a portion of sidewalls of the contact hole. The metal layer in contact with the doped layer may react with the doped layer to form metal compounds.

A semiconductor structure is also provided in the present invention. The semiconductor structure may include a base substrate including a substrate, a gate structure on the substrate, source and drain doped regions in the substrate on both sides of the gate structure, and a dielectric layer on the substrate and top of the gate structure. The semiconductor structure may also include a conductive plug penetrating through the dielectric layer and into each of the source and drain doped regions. Further, the semiconductor structure may include a doped layer in each of the source and drain doped regions, with doped ions, and surrounding a bottom portion of the conductive plug. Concentration of the doped ions in the doped layer may be uniform.

In one embodiment, the base substrate may include a first transistor region and a second transistor region. The gate structure may include a first gate structure in the first transistor region and a second gate structure in the second transistor region. The source and drain doped regions may include first source and drain doped regions in the substrate on both sides of the first gate structure in the first transistor region, and second source and drain doped regions in the substrate on both sides of the second gate structure in the second transistor region. The doped layer may include a first doped layer in each of the first source and drain doped regions, and a second doped layer in each of the second source and drain doped regions. The doped ions may include first doped ions in the first doped layer, and second doped ions in the second doped layer.

In one embodiment, the first transistor region may be used to form an NMOS transistor, thus the first doped ions may be phosphorus ions. In certain embodiments, the first doped ions may be arsenic ions, or antimony ions, etc. In one embodiment, the second transistor region may be used to form a PMOS transistor, thus the second doped ions may be boron ions. In certain embodiments, the second doped ions may be indium ions.

Accordingly, in the present invention , the source and drain doped regions may be doped by the doping process to form the doped layer in each of the source and drain doped regions via the bottom and a portion of sidewalls of the contact hole. The doped layer may reduce the resistance between each of the source and drain doped regions and the conductive plug. After doping the source and drain doped regions, the doped ions may be evenly distributed in the source and drain doped regions via the bottom and a portion of sidewalls of the contact hole. Therefore, the resistivity between the conductive plug and each of the source and drain doped regions may be uniform, and the performance of the formed semiconductor structure may be improved.

Further, before forming the conductive plug, the anti-diffusion process may be performed on the doped layer. The anti-diffusion process may reduce the diffusion of the doped ions in the doped layer toward the surface of the doped layer. As a result, the concentration of the doped ions in the doped layer may be increased, and the resistance between the conductive plug and each of the source and drain doped regions may be further reduced. Therefore, the performance of the formed semiconductor structure may be further improved.

## Claims

1. A method for fabricating a semiconductor structure, comprising:
forming a base substrate, including a substrate, a gate structure on the substrate, source and drain doped regions in the substrate on both sides of the gate structure, and a dielectric layer on the substrate and on top of the gate structure;
forming a contact hole, penetrating through the dielectric layer, wherein a bottom of the contact hole extends into each of the source and drain doped regions;
forming a doped layer, in each of the source and drain doped regions by a doping process via the bottom and a portion of sidewalls of the contact hole; and
forming a conductive plug in the contact hole.

2. The method according to claim 1, wherein:
the doping process is an isotropic process; and
the doping process includes a plasma doping process.

3. The method according to claim 1 or 2, wherein:
the semiconductor structure includes an NMOS transistor, and the doped layer is doped with one or more of phosphorus ions, arsenic ions, and antimony ions; and/or
the semiconductor structure includes a PMOS transistor, and the doped layer is doped with one or more of boron ions and indium ions.

4. The method according to anyone of the claims 1-3, wherein:
a concentration of doped ions in the doped layer is greater than 5×1014 atoms/cm3;
a doping dose is in a range of approximately 1×1015 atoms/cm3 - 5×1015 atoms/cm3;
a doping energy is in a range of approximately 10 eV - 20 KeV;
a pressure is in a range of approximately 1 mtorr - 1000 mtorr; and
a doping temperature is in a range of approximately 25 °C - 800 °C.

5. The method according to anyone of the claims 1-4, before forming the conductive plug in the contact hole, further including:
performing an anti-diffusion treatment on the doped layer.

6. The method according to claim 5, wherein:
the anti-diffusion treatment is performed on the doped layer by an ion implantation process to dope the doped layer with heavy ions; and
wherein preferably: an atomic weight of the heavy ions is larger than an atomic weight of ions doped in the doped layer.

7. The method according to claim 6, wherein process parameters of the ion implantation process include:
an implantation energy in a range of approximately 200 eV - 20 KeV;
an implantation dose lower than 1×1014 atoms/cm3; and
an implantation angle in a range of approximately 0° - 20°.

8. The method according to anyone of the claims 5-7, wherein:
the anti-diffusion treatment is performed on the doped layer by a plasma doping process to dope the doped layer with heavy ions; and
an atomic weight of the heavy ions is larger than an atomic weight of ions doped in the doped layer.

9. The method according to claim 8, wherein:
the source and drain doped regions are for forming an NMOS transistor, the doped ions include phosphorus ions; and the heavy ions include one or more of arsenic ions and antimony ions; and/or
the source and drain doped regions are for forming a PMOS transistor, the doped ions include boron ions; and the heavy ions include indium ions.

10. The method according to anyone of the claims 1-9, after forming the doped layer and before forming the conductive plug, further including:
forming a metal layer on the bottom and sidewalls of the contact hole, wherein the metal layer in contact with the doped layer reacts with the doped layer to form metal compounds.

11. The method according to anyone of the claims 1-10, wherein:
the base substrate includes a first transistor region and a second transistor region;
the gate structure includes a first gate structure in the first transistor region and a second gate structure in the second transistor region;
the source and drain doped regions include first source and drain doped regions in the substrate on both sides of the first gate structure in the first transistor region, and second source and drain doped regions in the substrate on both sides of the second gate structure in the second transistor region; and
the doped layer includes a first doped layer on a surface of each of the first source and drain doped regions, and a second doped layer on a surface of each of the second source and drain doped regions.

12. The method according to claim 11, wherein the doping process for doping the source and drain doped regions includes:
forming a first photoresist layer in the contact hole and on the dielectric layer in the first transistor region;
doping the second source and drain doped regions by a second doping process with the first photoresist layer as a mask to form the second doped layer in each of the second source and drain doped regions via the bottom and a portion of sidewalls of the contact hole in the second transistor region;
removing the first photoresist layer;
forming a second photoresist layer in the contact hole and on the dielectric layer in the second transistor region;
doping the first source and drain doped regions by a first doping process with the second photoresist layer as a mask to form the first doped layer in each of the first source and drain doped regions via the bottom and a portion of sidewalls of the contact hole in the first transistor region; and
removing the second photoresist layer.

13. The method according to claim 12, before forming the conductive plug in the contact hole, further including: performing an anti-diffusion treatment on the doped layer; and wherein preferably, the anti-diffusion treatment includes: performing a second anti-diffusion treatment on the second doped layer with the first photoresist layer as a mask after doping the second source and drain doped regions by the second doping process; and performing a first anti-diffusion treatment on the first doped layer with the second photoresist layer as a mask after doping the first source and drain doped regions by the first doping process.

14. A semiconductor structure, comprising:
a base substrate, including a substrate, a gate structure on the substrate, source and drain doped regions in the substrate on both sides of the gate structure, and a dielectric layer on the substrate and on top of the gate structure;
a conductive plug, penetrating through the dielectric layer and into each of the source and drain doped regions; and
a doped layer, in each of the source and drain doped regions, with doped ions, and surrounding a bottom portion of the conductive plug.

15. The semiconductor structure according to claim 14, wherein:
the base substrate includes a first transistor region and a second transistor region;
the gate structure includes a first gate structure in the first transistor region and a second gate structure in the second transistor region;
the source and drain doped regions include first source and drain doped regions in the substrate on both sides of the first gate structure in the first transistor region, and second source and drain doped regions in the substrate on both sides of the second gate structure in the second transistor region;
the doped layer includes a first doped layer on a surface of each of the first source and drain doped regions, and a second doped layer on a surface of each of the second source and drain doped regions; and
the doped ions include first doped ions in the first doped layer, and second doped ions in the second doped layer; and
wherein preferably:
the first transistor region includes an NMOS transistor, the first doped ions include one or more of phosphorus ions, arsenic ions, and antimony ions; and the second transistor region includes a PMOS transistor, the second doped ions include one or more of boron ions and indium ions.
